Europäisches Patentamt

European Patent Office

Office européen des brevets

(19)

(11) **EP 1 304 582 A1**

(12) ## EUROPEAN PATENT APPLICATION

(43) Date of publication:
    **23.04.2003 Bulletin 2003/17**

(51) Int Cl.$^7$: **G01R 33/46**

(21) Application number: **02256918.0**

(22) Date of filing: **04.10.2002**

(84) Designated Contracting States:
    **AT BE BG CH CY CZ DE DK EE ES FI FR GB GR
    IE IT LI LU MC NL PT SE SK TR**
    Designated Extension States:
    **AL LT LV MK RO SI**

(30) Priority: **17.10.2001 US 330051 P**

(71) Applicant: **Pfizer Products Inc.
    Groton, Connecticut 06340 (US)**

(72) Inventor: **Massefski, Walter William
    Sharon, Massachusetts 02067 (US)**

(74) Representative: **Sewell, Richard Charles et al
    UK Patent Department,
    Pfizer Limited,
    Ramsgate Road
    Sandwich, Kent CT13 9NJ (GB)**

(54)    **Method for enhancing NMR chemical structure determination**

(57)    A method for enhancing the NMR spectroscopy structural analysis of compounds and particularly the structural analysis of compounds used in developing viable drugs, by increasing signal to noise (S/N) ratio of obtained spectra by collecting and storing NMR in a standard data matrix and generating a point by point weighting function for each dimension of the matrix..

EP 1 304 582 A1

## Description

### FIELD OF THE INVENTION

This invention relates to methods of enhancing determination of chemical structure and particularly to the enhancement of NMR spectroscopy in effecting such determinations.

### BACKGROUND OF THE INVENTION

NMR (nuclear magnetic resonance) spectroscopy is a process by which a chemical substance is placed in a high magnetic field and subjected to a series of RF pulses in order to deduce the chemical structure of the substance. This process is typically employed in the analysis of substances which have the potential of becoming drugs.

The NMR spectroscopy method suffers however from low sensitivity relative to other spectroscopic techniques. It is thus not uncommon to need 10-100 mM solutions of chemical substances, in appropriate solvents, to utilize the full range of NMR experimental techniques required to deduce the chemical structure of a substance.

Even at magnetic field strengths of 10 Tesla and above, NMR spectroscopy is plagued by the fact that nuclear spins produce very weak signals. Much of the history of NMR development, both hardware and pulse/software methods, has arisen from the need to boost sensitivity. One of the most significant improvements in NMR sensitivity came with the advent of Fourier Transform (FT) NMR in the 1960s, allowing for the routine use of rapid signal averaging. The low sensitivity of NMR spectroscopy has also led to the development of many improvements, both hardware and software, which have as their goal the increase of the sensitivity of NMR. In recent times such developments have included higher field magnets, smaller probe receiver coil geometries, cryocooled probes and preamplifiers, and pulsed field gradients, as hardware methods to increase the size of the NMR signal and/or decrease the amount of background noise, both random and systematic. Pulse methods for increasing sensitivity include Rance's 2D/3D sensitivity enhancement (J. Cavanagh and M. Rance, "Sensitivity-Enhanced NMR Techniques for the Study of Biomolecules," Annu. Rep. NMR Spectrosc., 27, 1 (1993)); and various non-FT methods for predicting the size and frequency of NMR signals (Dunkel R. Mayne CL. Pugmire RJ. Grant DM. "Improvements in the computerized analysis of 2D INADEQUATE spectra" Analytical Chemistry. 64(24):3133-49, (1992)); including the filter diagonalization method (FDM) (V.A. Mandelshtam , "FDM: the Filter Diagonalization Method for data processing in NMR experiments" Progress in NMR Spectroscopy 38, 159-196 (2001). These have shown tremendous promise for increasing the lower limit of detection or decreasing the requisite data acquisition time for various experiments. A recent development is the construction of cryogenic NMR probes, where the receiver coil in an NMR probe is cooled to 15-30°K while holding the sample material at room temperature or above. The cryoprobe has been reported to deliver an increase in signal to noise ratio in the 2-5 fold range relative to conventional probes. Other methods have been used to enhance the signal itself. Thus, for example, Fourier transform NMR spectrometers routinely take advantage of simple signal averaging to improve interpretation of signals in developing of chemical structures and the like.

### SUMMARY OF THE INVENTION

It is an object of the present invention to provide an effective method of data collection and processing, which significantly increases the (signal to noise ratio) S/N of typical NMR readings to provide enhanced results such as for chemical structural determinations.

Generally the present invention comprises a method for enhancing the NMR spectroscopy structural analysis of compounds and particularly the structural analysis of compounds used in developing viable drugs, by increasing signal to noise (S/N) ratio of obtained spectra (reference to this method is accordingly with the sobriquet, "LoNoise").

The steps of the method of the present invention comprise:

a) subjecting a compound, such as one synthesized for drug development or analysis, to NMR spectroscopy or similar spectra analysis;

b) collecting and storing NMR or other spectra data obtained for the compound in a standard data matrix with a dimensionality that is one-higher than the experiment dimensionality (e.g., a one-dimensional (1D) experiment requires a two-dimensional (2D) data matrix; a 2D experiment requires a three-dimensional (3D) dataset, etc.; this is preferably easily accomplished by writing an extra dimension into a pulse sequence using a dummy incrementing variable which does not affect the experiment; with a 1D acquisition, the data set is broken into a series of bundles, and each bundle is stored as a row in the data matrix and the free induction decay (FID) data is processed in one dimension only, and this half-processed data matrix is used to generate the point by point weighting function).

c) generating a point by point weighting function for each dimension. This is accomplished by determining the mean and standard deviation of each point over the entire set of rows (bundles). The ratio of the mean to the standard deviation at each point is used as the weighting factor, based on the principle that this ratio is larger when the data is correlated;

d) obtaining a final spectrum as an average of the entire dataset over each dimension multiplied by the point by point weighting for that dimension, i.e.,

$$x(i) = ( \Sigma\ data(i,j) / N ) (m(i) / \sigma(i))$$

where (i) is the (i)th point in the spectrum, (j) is the row number, N is the total number of acquisitions, m(i) is the mean of the (i)th point over all rows, and $\sigma(i)$ is the standard deviation of the (i)th point over all rows. Whereas, if the mean is much greater than the standard deviation the point is increased in magnitude, and whereas if the standard deviation is greater than the mean then the point is reduced; and

e) using the final spectrum to determine structure of the compound.

In the absence of the statistics term the result would be exactly the same as if all transients were collected into a single FID and averaged.

The above and other objects, features and advantages of the present invention will become more evident from the following discussion and drawings in which:

SHORT DESCRIPTION OF THE DRAWINGS

Figure 1 is a graphical depiction of the averaging method of the present invention as applied to a signal, as compared to a conventional signal averaging method;

Figure 2 has plots a-c which are respective comparative 13C NMR scans of azithromycin with use of the prior art method (512 scans); the same compound being scanned according to the method of the present invention with 32 bundles and 4 scans per bundle (128 scans); and with 32 bundles and 16 scans per bundle (512 scans);

Figure 3 depicts comparison scans a and b using the method of the present invention and that of a prior art method where noise and signal would normally not be separable;

Figure 4 is a plot of scans using the method of the present invention and that of the prior art, illustrating the non-linear nature of the method of the present invention;

Figure 5 is a plot showing that the method of the present invention follows the same square root of N rule as a conventional NMR acquisitions; and

Figure 6 is a plot of extrapolated bundles of signal to noise ratios.

DETAILED DESCRIPTION OF THE INVENTION AND THE DRAWINGS

In order to illustrate the efficacy and basis of the present invention a series of comparative experiments were run with NMR data acquisition and with application of prior art signal averaging and signal processing according to the present invention. The results thereof are depicted in the Figures. All NMR experiments shown in the Figures were run at 500 MHz on a Bruker DMX-500 spectrometer operating with an inverse broadband probe, temperature control, and pulsed field gradients. Carbon 1D NMR spectra were acquired using 32768 total data points over 220 ppm and processed to 16384 points using 1 Hz line broadening for weighting. The delay between scans was typically 0.7 seconds, and the pulse tip angle was 60 degrees and Waltz (7) proton decoupling was used.

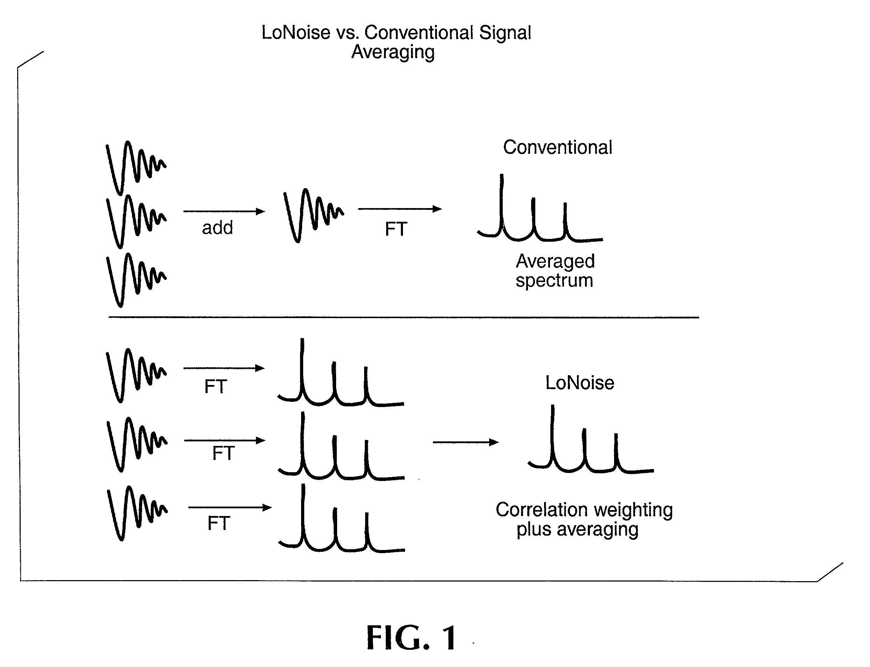

As described above, for a 1D acquisition, the data set is broken into a series of bundles, and each bundle is stored as a row in the data matrix. The free induction decay (FID) data is processed in one dimension only, and this half-processed data matrix is used to generate the point by point weighting function. The data set at this point looks like a stacked plot series and this is illustrated in Figure 1.

Figure 1 is a graphical depiction of the LoNoise method. In a conventional acquisition a number of free-induction decays (FIDs) are added together to form a single average FID, which is then processed into a spectrum. In LoNoise acquisition the same number of FIDs is stored as a set of signal-averaged bundles, each bundle is processed separately into a spectrum (albeit with lower S/N than the total), and the correlations between these spectra are used to determine a point by point weighting. Then, all of the bundles are added together, averaged, and the point by point weighting is applied. In the absence of this weighting the LoNoise and conventional spectrum are the same.

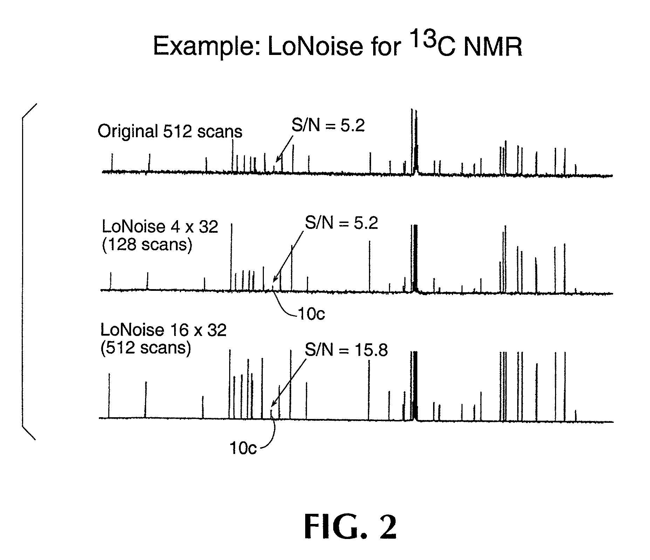

The enhancement with the use of the present invention is in the range of 3-6 fold, relative to prior art methods of signal averaging (e.g., Figure 2, plot a), as observed in the experiments depicted in plots a-c of Figure 2. It has been empirically determined that 16-32 rows or bundles (Figure 2, plot c) are preferred to produce reasonable statistics. A 128 scan experiment (Figure 2, plot b) is therefore 4 transients per bundle and 32 bundles per experiment.

Plots a-c of Figure 2 illustrate at least two points: 1) the sensitivity enhancement with use of the method of the present invention can be quite dramatic for very little increased acquisition and processing effort, and 2) the sensitivity enhancement is non-linear. It is clear that the most upfield carbon signals, which arise from methyl carbons which are stronger than the quarternary downfield carbons, also change their S/N much more dramatically. In this illustration, the S/N improvement is approximately 3-fold for the quarternary carbon at 69.6 ppm, but nearly 6-fold for the methyl carbon signal at 10.0 ppm.

Plots b-c of Figure 2 are examples of the LoNoise method applied to 1D $^{13}$C NMR. The samples

scanned were obtained from 29 mg of research grade azithromycin dissolved in 0.6 ml DMSO and placed in a 5mm NMR tube. The top spectrum (Figure 2, plot a) is a conventional 512 scan acquisition, and a specific carbon 10a at 69.6 ppm is highlighted because it is the weakest signal in the spectrum. The bottom spectrum (Figure 2, plot c) is the same number of scans acquired using the LoNoise method, using 32 bundles with 16 scans per bundle. The S/N of the peak 10c at 69.6 ppm is approximately three times greater than the same peak in the conventional spectrum. The middle spectrum (Figure 2, plot b) is 32 bundles with only 4 scans per bundle, and shows that the equivalent S/N for the peak 10c at 69.6 ppm can be achieved in one-quarter the number of scans using the LoNoise method.

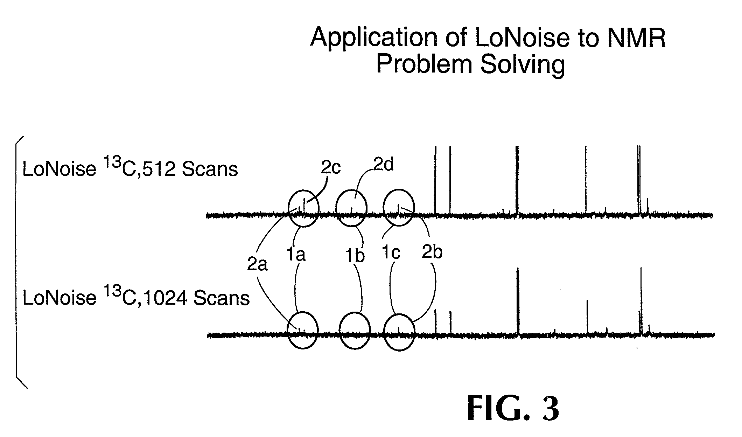

Plots a and b of Figure 3 demonstrate the practical utility of the method of the present invention. In these plots the $^{13}$C spectrum of a previously unknown material was acquired conventionally according to prior art methods (1024 scans- Figure 3, plot b) and with the method of the present invention (Figure 3, plot a -16 scans/bundle times 32 bundles, or 512 total scans). The chemical structure (not shown) suggests four quaternary carbons within the chemical shift region defined by the three circles 1a-c. One of these carbons is split by a carbon-fluorine one-bond coupling, and the upfield member of this doublet overlaps with a second carbon signal. The conventional spectrum in Figure 3, plot b, shows no more than two of these signals 2a-b, but the spectrum obtained with the method of the present invention shows all four (2a-d) in half the total acquisition time. Clearly, the method of the present invention has the ability to extract information which is otherwise lost by simple signal averaging.

Figure 3, plot a comprises an example of the LoNoise method applied to the $^{13}$C spectrum of an unknown sample. The reaction chemistry suggested there should be four quaternary carbon peaks within the three circles shown in the bottom spectrum (Figure 3, plot b), which is weakened by exchange broadening. The LoNoise spectrum of Figure 3, plot a (top), is acquired with half the total number of scans as the conventional spectrum and clearly shows these peaks

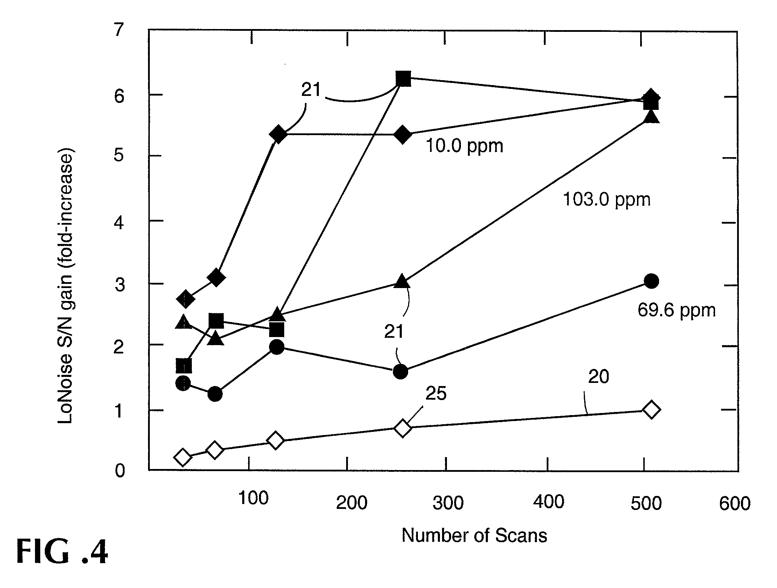

The above data exemplify the qualitative nature of the present method, but do not adequately describe the non-linear behavior of the approach. In order to better understand this phenomenon, a series of experiments was conducted on a sample of azithromycin in DMSO-d6 in which the present method of S/N enhancement was measured as a function of signal strength and number of total scans, with the results shown in Figure 4.

Figure 4 is a plot which illustrates the non-linear nature of the LoNoise method. The line 20 marked conventional shows the theoretical square root gain in sensitivity as a function of the number of scans. The solid points 21 show the LoNoise S/N for four chemical shifts of varying signal intensity in the $^{13}$C spectrum of

the azithromycin sample from Figure 2: 69.6 ppm (weak), 45.6 ppm (moderate), 103.0 ppm (strong), 10.0 ppm (very strong). The LoNoise spectra were all acquired using 32 bundles, with 1, 2, 4, 8, or 16 scans per bundle. The S/N gain is shown as a multiple of that observed for the conventional 512 scan spectrum corrected for the reduced number of total scans. For example, the raw S/N of the peak at 69.6 ppm in the 128 total scan LoNoise spectrum is 5.1:1, which is compared to 2.6:1 (5.2:1 observed in the conventional 512 scan spectrum times the square root of (128 scans / 512 scans) for a reported gain of 1.98-fold relative to a conventional 128 scan acquisition.

In order to keep the statistics constant, each experiment was run with 32 bundles, so that the number of scans per bundle was 1, 2, 4, 8, and 16 for the five points shown for each chemical shift. Each point is shown as a multiple of the anticipated conventional S/N for that number of scans. Included in this figure, in open diamond symbols 25, is the square root dependence expected for conventional acquisition, where 1.0 is defined as the S/N measured for the 512 scan conventional acquisition.

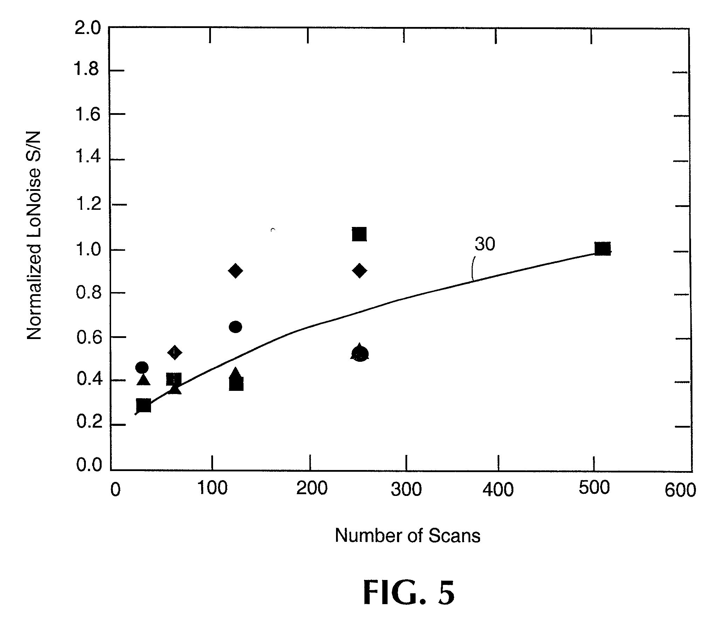

The data shown in Figure 4 includes points from four chemical shifts which have different intrinsic S/N, varying from 69.6 ppm (weak) to 10.0 ppm (very strong). It appears that the effect of the present method reaches a maximum of approximately 6-fold relative to conventional acquisition and processing, and that this maximum is reached more quickly for strong peaks than for weak ones. These data are normalized to their respective 512 scan values in Figure 5, showing that the results obtained with the method of the present invention continues to follow the expected square root law that governs conventional signal averaging. This suggests that the S/N enhancement that is observed in the present method is an integral function of the average S/N present in the bundle for a given peak.

The plot of Figure 5 shows that the LoNoise method roughly follows the same square root of N rule as conventional NMR acquisition. The points shown are the same data as Figure 4 except they are normalized relative to the 512 scan acquisition at 1.0. The solid line 30 is the theoretical square root function. The symbol types are the same as for Figure 4.

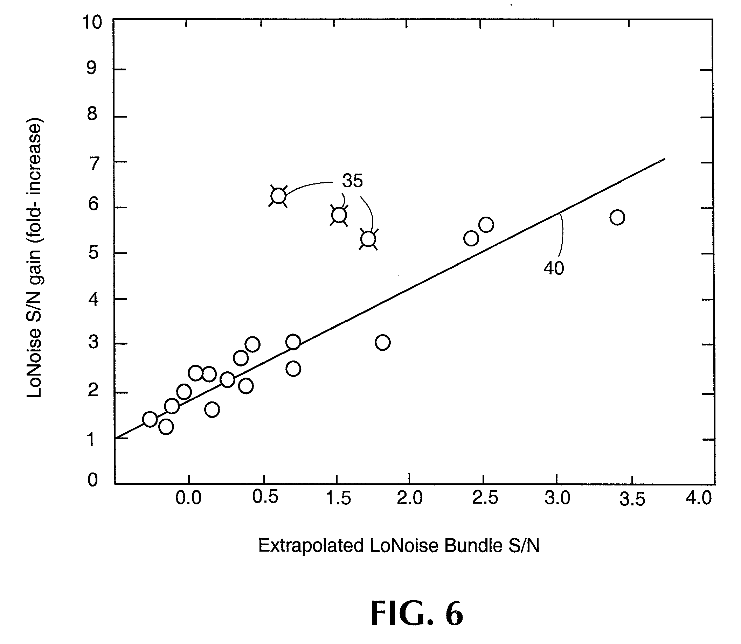

Figure 6 shows the data from Figure 4, but now the S/N enhancement is plotted as a function of the extrapolated bundle S/N for that peak. For example, if the measured S/N for a peak in the 512 scan experiment is 10:1, the extrapolated bundle S/N for a 16 scan bundle is $10 \times \sqrt{(16/512)}$, or 1.77:1. The data follow a good straight line relationship (multiplier = 1.0 + 1.61*(per bundle S/N), r=0.96 (N=17)) and provide the basis for the nonlinear effect. This figure also demonstrates that this method makes it possible to clearly observe signals that would otherwise be lost in the noise.

The basis for LoNoise non-linearity is shown in Figure 6. The data from the four peaks exemplified in Figures 4 and 5 are plotted relative to their extrapolated single bundle S/N. A value of extrapolated LoNoise S/N less than 1.0 means that the signal intensity is less than that of the noise and would be undetectable by visual inspection of the spectrum. The three points 35 with x marked through them were not included in the calculation of the slope and intercept of the line 40.

The above clearly shows that using 1D $^{13}$C NMR as a representative example in which the inherent signal to noise is low, that the invention as applied to NMR data acquisition and processing results in real and useful gains in signal to noise. The method employed for weighting the data is extremely simple, and does a good job of enhancing signals at the expense of noise in a predictable manner. The data shown in Figure 6 illustrate both the magnitude of the enhancement (the slope of the line 40) and the predictability of the enhancement (the extent to which the points cluster around the line).

It is possible to use the same type of analysis to test other statistical methods to develop the point by point weighting function with an eye toward improving the enhancement and the predictability thereof. Accordingly, this evaluations combined with empirical calibrations makes it possible to create an algorithm which keeps the present invention enhancement and makes it the same for all peaks, thereby regaining amplitude accuracy in the final spectrum.

The present method can be easily applied to 2D NMR experiments in which the necessary S/N is obtained through signal averaging, such as HSQC or HMBC (**h**eteronuclear **s**ingle **q**uantum **c**orrelation; **h**eteronuclear **m**ultiple **b**ond **c**orrelation), or INADEQUATE and its variants as described by R.R. Ernst, G. Bodenhausen and A. Wokaun, in"Principles of nuclear magnetic resonance in one and two dimensions,"(London: Oxford University Press, 1986). Though still within the purview of the present invention, the method is less useful for experiments in which only a few transients per row are typically acquired and 16-32 bundles per processed row are preferred for the simple statistics employed, although fewer bundles may be adequate if more sophisticated statistics or correlation methods are employed.

Though the present application is focused on methods which use the spectral data for finding correlation information across the bundles in each dimension, it may be possible to work out an equivalent approach that used FID bundles as well. This would lead to a straightforward way to use hardware or firmware DSP technology and tie it directly to hardware data acquisition, thereby making it unnecessary to acquire an extra dimension worth of data.

It is understood that the above description and specific examples are merely exemplary of the present invention and that changes may be made in method of scanning, parameters, materials and the like as well as to other spectra methods having requirements of signal to noise separation, without departing from the scope of the present invention as defined in the following claims.

**Claims**

1. A method for enhancing the structural analysis of a compound, by increasing signal to noise (S/N) ratio of structural spectra of said compound, obtained from a spectra producing device, said method comprising the steps of:

   a) subjecting a compound to a scan with a spectroscopy device which provides spectra data for determining structure of said compound;
   b) collecting said spectra data with any of a one-dimensional, two dimensional or three dimensional scan, and storing said data in a data matrix with a dimensionality that is one-higher than the dimensionality of the scan; wherein in each dimension of the data matrix there is a data set, with said data set being broken into a series of bundles with each bundle being stored as a row in the data matrix;
   c) generating a point by point weighting function for each dimension of the data matrix by determining a mean and standard deviation of each point over the entire series of rows and bundles with the ratio of mean to standard deviation at each point

   and obtaining a final spectrum as an average of the entire dataset over each dimension, multiplied by the point by point weighting for that dimension, in accordance with the following formula:

$$x(i) = (\Sigma\ data(i,j)\ /\ N\ )\ (m(i)/\sigma(i))$$

   where (i) is the (i)th point in the spectrum, (j) is the row number, N is the total number of acquisitions, m(i) is the mean of the (i)th point over all rows, and $\sigma(i)$ is the standard deviation of the (i)th point over all rows, wherein, if the mean is greater than the standard deviation the point is increased in magnitude, and wherein if the standard deviation is greater than the mean then the point is reduced; and
   e) using the final spectrum to determine structure of the compound.

2. The method of claim 1, wherein obtaining said data in the data matrix with a dimensionality that is one-higher than the dimensionality of the scan is effected by writing an extra dimension into a pulse sequence using a dummy incrementing variable which does not affect the scan

**3.** The method of claim 1, wherein free induction decay (FID) data is processed in one dimension only and processed FID data in the data matrix is used to generate the point by point weighting.

LoNoise vs. Conventional Signal Averaging

Conventional

add

FT

Averaged spectrum

LoNoise

FT

FT

FT

Correlation weighting plus averaging

**FIG. 1**

# Example: LoNoise for $^{13}C$ NMR

Original 512 scans   S/N = 5.2

LoNoise 4 x 32
(128 scans)   S/N = 5.2
   10c

LoNoise 16 x 32
(512 scans)   S/N = 15.8
   10c

## FIG. 2

EP 1 304 582 A1

Application of LoNoise to NMR
Problem Solving

LoNoise $^{13}$C,512 Scans

2c    2d

2a    1a    1b    1c    2b

LoNoise $^{13}$C,1024 Scans

FIG. 3

EP 1 304 582 A1

FIG .4

FIG. 5

EP 1 304 582 A1

**FIG. 6**

EP 1 304 582 A1

**European Patent Office**

## EUROPEAN SEARCH REPORT

Application Number

EP 02 25 6918

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | V.A. MANDELSHTAM: "FDM: the filter diagonalization method ..." PROGRESS IN NUCLEAR MAGNETIC RESONANCE SPECTROSCOPY, vol. 38, March 2001 (2001-03), pages 159-196, XP002230301 pages 160 - 166, "Introduction" and "Spectral estimators ..." pages 188 - 191, "Signal averaging" and "Pseudo-noise averaging" pages 193 - 194, "Remaining problems" | 1-3 | G01R33/46 |
| A | V.A. MANDELSHTAM: "The Multidimensional Filter Diagonalization Method" JOURNAL OF MAGNETIC RESONANCE, vol. 144, 2000, pages 343-356, XP002230302 pages 343 - 346, "Introduction", "What is HIP?" and "Spectral Representations of the Fine List" pages 354 - 355, "Reduction of Noise Artifacts ..." and "Summary" | 1-3 | |
| A | R. DUNKEL ET AL.: "Computerized Analysis of 2D INADEQUATE Spectra" JOURNAL OF MAGNETIC RESONANCE, vol. 90, 1990, pages 290-302, XP002230303 * the whole document * | 1-3 | TECHNICAL FIELDS SEARCHED (Int.Cl.7) G01R |

The present search report has been drawn up for all claims

| Place of search | Date of completion of the search | Examiner |
|---|---|---|
| THE HAGUE | 7 February 2003 | Volmer, W |

EPO FORM 1503 03.82 (P04C01)